Europäisches Patentamt

European Patent Office

Office européen des brevets

(11) Veröffentlichungsnummer: **0 502 345 A1**

## (12) EUROPÄISCHE PATENTANMELDUNG

(21) Anmeldenummer: **92102451.9**

(22) Anmeldetag: **14.02.92**

(51) Int. Cl.5: **C08L 81/02**, //(C08L81/02, 61:06),(C08L81/02,25:18)

(30) Priorität: **27.02.91 DE 4106124**

(43) Veröffentlichungstag der Anmeldung:
**09.09.92 Patentblatt 92/37**

(84) Benannte Vertragsstaaten:
**BE DE FR GB IT**

(71) Anmelder: **BAYER AG**

**W-5090 Leverkusen 1 Bayerwerk(DE)**

(72) Erfinder: **Köhler, Burkhard, Dr.**
**Mündelheimer Strasse 94**
**W-4150 Krefeld(DE)**
Erfinder: **Sarabi, Bahman, Dipl.-Ing.**
**Oelhausenweg 55A**
**W-4150 Krefeld(DE)**
Erfinder: **Dorf, Sabine, Dr.**
**Bodelschwinghstrasse 16**
**W-4150 Krefeld(DE)**
Erfinder: **Heinz, Hans-Detlef, Dr.**
**Breslauer Strasse 31**
**W-4150 Krefeld(DE)**
Erfinder: **Jonas, Friedrich, Dr.**
**Krugenofen 15**
**W-5100 Aachen(DE)**

(54) **PAS mit verminderter Schwimmhautbildung und guten mechanischen Eigenschaften.**

(57) Die Erfindung betrifft Polyarylensulfide (PAS), insbesondere Polyphenylensulfid (PPS) mit verminderter Schwimmhautbildung (Flash).

EP 0 502 345 A1

Die Erfindung betrifft Polyarylensulfide (PAS), insbesondere Polyphenylensulfid (PPS) mit verminderter Schwimmhautbildung (Flash).

Polyarylensulfide sind bekannt (z.B. US-A 3 354 129, EP-A 171 021). Sie sind inerte, hochtemperaturbeständige Thermoplaste, die einen hohen Füllgrad, z.B. mit Glasfasern und/oder anderen anorganischen Füllstoffen erlauben. Der Einsatz dieser Polymeren, insbesondere des Polyphenylensulfids (PPS), nimmt in Bereichen zu, die bisher Duroplasten vorbehalten waren

PAS hat unbefriedigende mechanischen Eigenschaften für einige Anwendungen im Spritzgußbereich. Insbesondere sind Randfaserdehnung und Schlagzähigkeit für die Praxis nicht ausreichend. Ferner ist die Schwimmhautbildung heim Spritzguß ein Problem bei der Verarbeitung von PPS-Mischungen.

Ferner lassen sich die mechanischen Eigenschaften von PAS mit Polyisocyanaten verbessern (z.B. JP-A 01 118-572). Jedoch ist der Einsatz von Isocyanaten aus Gründen der Arbeitssicherheit problematisch.

Viele PPS-Mischungen(Compounds) weisen das Problem der Schwimmhautbildung auf(Flash), d.h. daß die Polymerschmelze bei der Spritsgußverarbeitung aus Spalten der Form austritt und Grate (Schwimmhäute) bildet.

Wünschenswert sind daher PAS-Compounds, die bei guter Mechanik und genügender Fließfähigkeit nur geringe Schwimmhautbildung aufweisen.

Es wurde nun gefunden, daß Mischungen aus PAS, ausgewählten Nitroverbindungen und gegebenenfalls Novolaken eine Verminderung der Schwimmhautbildung (Flash) bewirken.

Gegenstand der Erfindung sind Mischungen aus

A) 99,8 bis 20 Gew.-% Polyarylensulfiden, vorzugsweise Polyphenylensulfid,

B) 0,2 bis 10 Gew.-% von m-Nitrobenzaldehyd oder Nitroverbindungen der Formeln (I) bis (III),

$$((NO_2)\text{-Phenylen-CH} = N\text{-})_y\text{-R} \qquad (I) \, ,$$

$$NO_2\text{-Phenylen-SO}_2\text{-Phenylen-NO}_2 \qquad (II) \, ,$$

$$NO_2\text{-Phenylen-SO}_2\text{-O-Ar-O-SO}_2\text{-Phenylen-NO}_2 \qquad (III) \, ,$$

wobei

R    für einen di- oder trivalenten aromatischen $C_{6-14}$ oder hetero(O,N,S)aromatischen oder aliphatischen $C_{2-22}$-Rest steht,

Ar    für einen $C_{6-18}$-Arylenrest, der aus einem oder mehreren Phenylenresten aufgebaut ist, die durch chemische Bindungen oder Alkylen- oder Alkylidenreste verknüpft sein können, steht

und

y    für 2 oder 3 steht,

wobei

B) auch eine Mischung aus

C1) 0,1 bis 5 Gew.-% m-Nitrobenzaldehyd oder Verbindungen der Formeln (I) bis (II) und

C2) 0,1 bis 5 Gew.-% eines Kondensates aus Phenolen und Ketoverbindungen oder ein Polymerisat von Alkenylphenolen sein kann und

D) 0-79,8 Gew.-% mineralischen Füll- und Verstärkungsstoffen.

Die Mischungen werden in einem Extruder bei Temperaturen von 300-350°C in der Schmelze hergestellt.

Beispiele für erfindungsgemäße Stoffe der Formel (I) sind die Azomethine, erhältlich aus m-Nitrobenzaldehyd und Diaminen, wie z.B. Methylendianilin, m-Phenylendiamin, Hexamethylendiamin oder Triaminen wie Tris-4-aminophenylmethan oder Melamin.

Die Herstellung der Verbindungen der Formel (I) erfolgt z.B. durch Umsetzung von m-Nitrobenzaldehyd mit dem Amin in Gegenwart eines Azeotropbildners (z.B. Organikum, Aufl. 11, VEB-Verlag, Seite 425).

Als erfindungsgemäßer Stoff der Formel (II) werden vorzugsweise 3,3'- oder 4,4'-Dinitrodiphenylsulfon eingesetzt, die z.T. kommerziell erhältlich sind oder bei der technischen Synthese der entsprechenden Sulfochloride anfallen.

Verbindungen der Formel (III) werden aus Bisphenolen wie Hydrochinon, Resorcin, Dihydroxybiphenyl oder Bisphenol-A und o-, m- oder p-Nitrobenzolsulfochlorid, vorzugsweise in Gegenwart von Hilfsbasen, hergestellt.

Als Komponente C2) werden Kondensate von Phenolen wie Phenol, Kresol oder anderen alkylsubstituierten Phenolen, mit Aldehyden oder Ketonen, wie Formaldehyd, Furfural, Benzaldehyd, Acetaldehyd, Cyclohexanon oder Aceton, eingesetzt. Beispiele für solche Verbindungen sind Bisphenol-A, Bisphenol-F, Bisphenol-Z oder vorzugsweise Kondensate, wie sie z.B. in Houben-Weyl, Methoden der organischen Chemie, Band E 20/Teil 3, Georg Thieme Verlag, Stuttgart, New York 1987, Seite 1794-1810 und der dort zitierten Literatur beschrieben sind.

Erfindungsgemäß werden handelsübliche, bevorzugt mit Polyurethanfilmbildnern oder Epoxydfilmbildnern und Amino- oder Epoxysilanhaftvermittlern geschlichtete Glasfasern eingesetzt. Sie haben einen Durchmesser von 1 bis 20 $\mu$m, vorzugsweise von 5 bis 13 $\mu$m. Es können Endlosglasfasern gewählt werden, bei denen die Länge der Fasern in der fertigen Abmischung 0,05 bis 10 mm, vorzugsweise 0,1 bis 2 mm, beträgt. Es können auch Endlosglasfasern (rovings) eingesetzt werden in Verfahren zur Herstellung von endlosverstärktem Unidirektionalverbund.

Gegebenenfalls können auch - insbesondere teilweise - anstelle der Glasfasern handelsübliche Glaskugeln eingesetzt werden, z.B. Ballotini-Glaskugeln.

Als weitere, mineralische Füllstoffe oder Zusatzstoffe seien Glimmer, Talkum, Quarzmehl, Metalloxide und Sulfide, z.B. $TiO_2$, ZnO, ZnS, Graphit, Ruß, Fasern, z.B. aus Quarz oder Kohlenstoff, Carbonate wie z.B. $MgCO_3$, $CaCO_3$ oder Sulfate wie z.B. $CaSO_4$ $BaSO_4$ genannt.

Als weitere übliche Zusatzstoffe können Pigmente, Entformungsmittel, E-Wachse, Fließhilfsmittel, Nucleierungsmittel oder Stabilisatoren eingesetzt werden.

Ferner können als organische Zusatzstoffe Bismaleinimide, wie 4,4'-Bismaleinimido-methylendianilin eingesetzt werden.

Es können 0 bis 300 Gew.-%, bezogen auf PAS, Füllstoffe und Zusatzstoffe eingesetzt werden.

Die erfindungsgemäßen Mischungen können auf übliche Weise zu Formteilen, Halbzeug, Leiterplatten, Fasern, Folien, Profilen usw. verarbeitet werden. Die erfindungsgemäßen Mischungen können generell in vorteilhafter Weise dort eingesetzt werden, wo thermoplastisch verarbeitbare Massen eingesetzt werden.

1. Compoundherstellung

Das verwendete PPS wies eine Schmelzviskosität von 45 bis 65 Pas (Schmelztemperatur = 310°C, Schergeschwindigkeit = $10^3$ 1/s) auf und wurde nach EP-A 171 021 hergestellt.

Als Glasfasern wurde die mit Epoxyfilmbildner und Epoxysilanhaftvermittler geschlichtete Schnittglasfaser zu 40 Gew.-% eingesetzt. Die Compoundierung der erfindungsgemäßen Mischungen erfolgte auf einem Doppelextruder SZK 32 von Werner & Pfleiderer bei 340°C. Die Viskosität der Compounds wurde bei einer Massetemperatur von 320°C und einer Schergeschwindigkeit von 1/1000 s durch Kapillarviskosimetrie bestimmt.

Die Herstellung von Flachstäben 80x10x4 $mm^3$ erfolgte entsprechend der beigefügten Konstruktionszeichnung mit der Möglichkeit der Gratbildung am Ende des Probekörpers. Die Ermittlung der mechanischen und thermischen Eigenschaften sowie die Gratmessung erfolgte an ein und demselben Probekörper. Die Gratbildung erfolgte in einer Spaltbreite von 10 bis 40 $\mu$m bei einem maximalen Werkzeuginnendruck von 800 bar und einer Werkzeugobertlächentemperatur von 140°C. Die Prüfung der mechanischen Eigenschaften wurde hinsichtlich der Biegefestigkeit, Randfaserdehnung (DIN 53 452), der Schlagzähigkeit (ISO 180 Methode 1C) untersucht. Die Gratmessung erfolgte optisch mittels eines Bildauswertegeräts der Firma Zeiss mit integriertem Mikroskop in der gesamten Probenbreite von 10 mm mit der Abtastrate von 10 $\mu$m. Die so ermittelte mittlere Gratlänge wurde an fünf Probekörpern gemessen.

Alle %-Angaben in den folgenden Beispielen sind Gew.-%-Angaben.

Vergleichsbeispiel 1

Gemischt wurden 59,8 Gew.-% PPS mit 40 Gew.-% Glasfasern und 0,2 Gew.-% E-Wachs.

Vergleichsbeispiel 2

Gemischt wurden 58,8 Gew.-% PPS mit 40 Gew.-% Glasfasern, 1 % 4,4'-Bismaleinimido-methylendianilin und 0,2 Gew.-% E-Wachs.

E-Wachs ist das handelsübliche Entformungswachs der Fa. Hoechst. Es handelt sich um Ester der sog. Montansäuren.

Beispiel 1

Gemischt wurden 57,8 Gew.-% PPS mit 40 % Glasfasern, 1 Gew.-% Vulkadur RB® (Phenolharz, Novolak aus Phenol und Formaldehyd), 1 Gew.-% m-Nitrobenzaldehyd und 0,2 Gew.-% E-Wachs.

Beispiel 2

Gemischt wurden 58,8 Gew.-% mit 40 Gew.-% Glasfasern, 1 Gew.-% 3,3'-Dinitrodiphenylsulfon und 0,2 Gew.-% E-Wachs.

Beispiel 3

Gemischt wurden 58,8 Gew.-% PPS mit 40 Gew.-% Glasfasern, 1 Gew.-% Bisphenol-A-bis-o-nitrobenzolsulfonsäureester und 0,2 Gew.-% E-Wachs.

Beispiel 4

Gemischt wurden 57,8 Gew.-% PPS mit 40 Gew.-% Glasfasern, 2 Gew.-% 4,4'-Bis-m-nitrobenzalamino-methylendianilin und 0,2 Gew.-% E-Wachs.

Beispiel 5

Gemischt wurden 58,8 Gew.-% PPS mit 40 Gew.-% Glasfaser, 1 Gew.-% m-Nitrobenzaldehyd und 0,2 Gew.-% E-Wachs.

Beispiel 6

Gemischt wurden 56,8 Gew.-% PPS mit 40 Gew.-% Glasfaser, 1 Gew.-% m-Nitrobenzaldehyd, 1 Gew.-% LyncurM®, ein Polyvinylphenol der Fa. Maruzen, und 0,2 Gew.-% E-Wachs.

Folgende Tabelle faßt die Ergebnisse zusammen:

| Beispiel | Izodschlagzähigkeit (kJ/qm) | Viskosität (Pa.s) | Flash[*] ($\mu$m) |
|---|---|---|---|
| Vergleich 1 | 42 | 200 | 470 |
| Vergleich 2 | 44 | 220 | 440 |
| Beispiel 1 | 44 | 190 | 320 |
| Beispiel 2 | 48 | 310 | 210 |
| Beispiel 3 | 46 | 220 | 350 |
| Beispiel 4 | 47 | 190 | 350 |
| Beispiel 5 | 42 | 210 | 280 |
| Beispiel 6 | | 190 | 330 |

[*] maximaler Werkzeuginnendruck: 800 mbar
Werkzeugoberflächentemperatur: 140°C
Massetemperatur: 340°C
Spalttiefe: 40 $\mu$m

Die erfindungsgemäßen Compounds weisen bei sehr guter Mechanik und guter bis ausreichender Fließfähigkeit eine deutlich gegenüber dem Stand der Technik verbesserte Fließfähigkeit auf.

**Patentansprüche**

1. Mischungen aus
   A) 99,8 bis 20 Gew.-% Polyarylensulfiden, vorzugsweise Polyphenylensulfid,
   B) 0,2 bis 10 Gew.-% von m-Nitrobenzaldehyd oder Nitroverbindungen der Formeln (I) bis (III),

   $((NO_2)$-Phenylen-CH = N-$)_y$-R      (I) ,

   $NO_2$-Phenylen-$SO_2$-Phenylen-$NO_2$      (II) ,

   $NO_2$-Phenylen-$SO_2$-O-Ar-O-$SO_2$-Phenylen-$NO_2$      (III) ,

wobei

R   für einen di- oder trivalenten aromatischen $C_{6-14}$ oder hetero(N,O,S)aromatischen oder aliphatischen $C_{2-22}$-Rest steht,

Ar  für einen $C_{6-18}$-Arylenrest, der aus einem oder mehreren Phenylenresten aufgebaut ist, die durch chemische Bindungen oder Alkylen- oder Alkylidenreste verknüpft sein können, steht

und

y   für 2 oder 3 steht,

wobei

B) auch eine Mischung aus

C1) 0,1 bis 5 Gew.-% m-Nitrobenzaldehyd oder Verbindungen der Formeln (I) bis (II) und

C2) 0,1 bis 5 Gew.-% eines Kondensates aus Phenolen und Ketoverbindungen oder ein Polymerisat von Alkenylphenolen sein kann und

D) 0-79,8 Gew.-% mineralischen Füll- und Verstärkungsstoffen.

2. Verwendung der Mischungen nach Anspruch 1 zur Herstellung geformter Körper.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| P,A | EP-A-0 428 020  (BAYER AG) <br> * Seite 3, Zeile 3 - Zeile 6; Ansprüche; Beispiele * <br> --- | 1,2 | C 08 L  81/02  // <br> (C 08 L  81/02 <br> C 08 L  61:06 ) <br> (C 08 L  81/02 <br> C 08 L  25:18 ) |
| A | DE-A-3 841 022  (BAYER AG) <br> * Seite 3, Zeile 36 - Zeile 41; Ansprüche * <br> --- | 1,2 | |
| A | EP-A-0 345 551  (BAYER AG) <br> * Seite 2, Zeile 45 - Zeile 54; Ansprüche 1-4 * <br> --- | 1,2 | |
| A | EP-A-0 345 550  (BAYER AG) <br> * Seite 4, Zeile 3 - Zeile 36 * <br> ----- | 1,2 | |

**RECHERCHIERTE SACHGEBIETE (Int. Cl.5)**

C 08 L
C 08 L
C 08 K

Der vorliegende Recherchenbericht wurde für alle Patentansprüche erstellt

| Recherchenort | Abschlußdatum der Recherche | Prüfer |
|---|---|---|
| DEN HAAG | 27-05-1992 | KLIER E.K. |

EPO FORM 1503 03.82 (P0403)